# EUROPÄISCHE PATENTANMELDUNG

(11) **EP 1 881 276 A1**
(43) Veröffentlichungstag der Anmeldung: **23.01.2008**
(21) Anmeldenummer: 07075607.7
(22) Anmeldetag: 15.07.2007
(51) Int. Cl.: F24F 6/06

(54) **Ventilator mit Kühleffekt durch Verdunstungskälte**

(30) Priorität: 18.07.2006 DE 102006033103; 10.02.2007 DE 102007006657
(71) Anmelder: Staege, Rüdiger, 14109 Berlin (DE)
(72) Erfinder: Staege, Rüdiger, 14109 Berlin (DE)

(57) **Zusammenfassung**

1. Die Erfindung betrifft einen Ventilator mit Kühleffekt durch Verdunstungskälte.
2. Bekannte Ventilatoren transportieren ein Gas, z.B. Luft, durch Drehung der Propellerflügel ohne das Gas zu kühlen.
3. Durch Verdunstung einer Flüssigkeit auf einem Körper, wird dem Körper Wärme entzogen; es entsteht Verdunstungskälte.
4. Wird den, z.B. aus porösem Material bestehenden, Propellerblättern eines Ventilators Flüssigkeit, z.B. Wasser in zu bestimmender Menge zugeführt, verdunstet die Flüssigkeit an der Oberfläche der sich drehenden Propellerblättern, es entsteht Verdunstungskälte.
5. Bei bereits vorhandenen, dem Stand der Technik entsprechenden Ventilatoren, werden feuchtigkeithaltende Materialien auf der Propellerfläche angebracht, die im feuchten Zustand den vergleichbaren Verdunstungskühleffekt bewirken, wie die angefeuchteten Propellerblätter des Erfindungsgegenstandes.
6. Bei einer i.d.R waagerecht angeordneten ventilatorähnlichen Vorrichtung in überwiegend scheibenförmiger Ausführung bewirkt das Auftragen von Flüssigkeit/Wasser auf die Oberfläche der schnell rotierenden Vorrichtung, dass durch die Verdunstung, der kühlende Luftstrom den thermischen Bedingungen zufolge, auch ohne Propellerunterstützung nach unten sinkt.
7. Um den Verdunstungskühleffekt verstärken zu können, werden den kühlenden feuchtigkeitabgebenden Propellerflügeln feuchtigkeitaufnehmende Materialien, die dem kühlenden Luftstrom Feuchtigkeit entziehen, nachgeordnet, damit erneut kühlende feuchtigkeitabgebende Propellerflügel einen Kühleffekt bewirken und den vorherigen Kühleffekt verstärken.

## Beschreibung

Der erfindungsgemäß vorgeschlagene Ventilator erzeugt im abgehenden Strom von Gasen, z.B. Luft einen Kühleffekt durch Verdunstungskälte.

In der weiteren Beschreibung wird nur von Luft berichtet, auch wenn andere Gase Bestandteil im Sinne der Beschreibung sind.

Die Funktion eines Ventilators ist als Gerät bekannt, das die Erzeugung eines Luftstroms bewirkt, ohne als Gerät von selbst Einfluß auf Veränderung der Luft (Temperatur, Luftfeuchtigkeit) zu nehmen.

Veränderungen der Temperatur oder der Luftfeuchtigkeit im Luftstrom eines Ventilators sind nur durch Zusatzeinrichtungen, wie z.B. eine verdunstungsfähige Flüssigkeit versprühende Sprühvorrichtung in den vom Ventilator verursachten Luftstrom oder einem vor- bzw. nachgeschalteten Kühl- oder Heizaggregat erreichbar.

Ventilatoren, deren Propellerflügel die Beschaffenheit des Luftstroms (Temperatur, Luftfeuchtigkeit) auf Grund ihrer Konstruktion, bzw. Beschaffenheit oder durch hinzufügen in den Propellerflügel anderer Stoffe, z.B. verdunstungsfähiger Flüssigkeit zum Erreichen von Verdunstungskälte beeinflusst, sind nicht bekannt. Unbekannt ist das Nachrüsten herkömmlicher Ventilatoren, bei denen bei Hinzufügung von Verdunstungsflächen auf den Propellerflügeln Verdunstungskälte erzeugt wird. Desweiteren unbekannt ist, dass im Luftstrom nach Erzeugung der Verdunstungskälte feuchtigkeitaufnehmende Materialien nachgeordnet sind.

Als Stand der Technik sind die Patentschriften CH 167 094 A, US 2006/0075898 A1 und US 6 017 188 A zu benennen.

Erfindungsgemäß wird vorgeschlagen, dass mindestens ein Propellerflügel eines Ventilators derart beschaffen ist, dass der Propellerflügel die aufgenommene Feuchtigkeit durch Verdunstung an die Umgebung abgibt und mit der so erzeugten Verdunstungskälte der abgehende Luftstrom gekühlt wird.

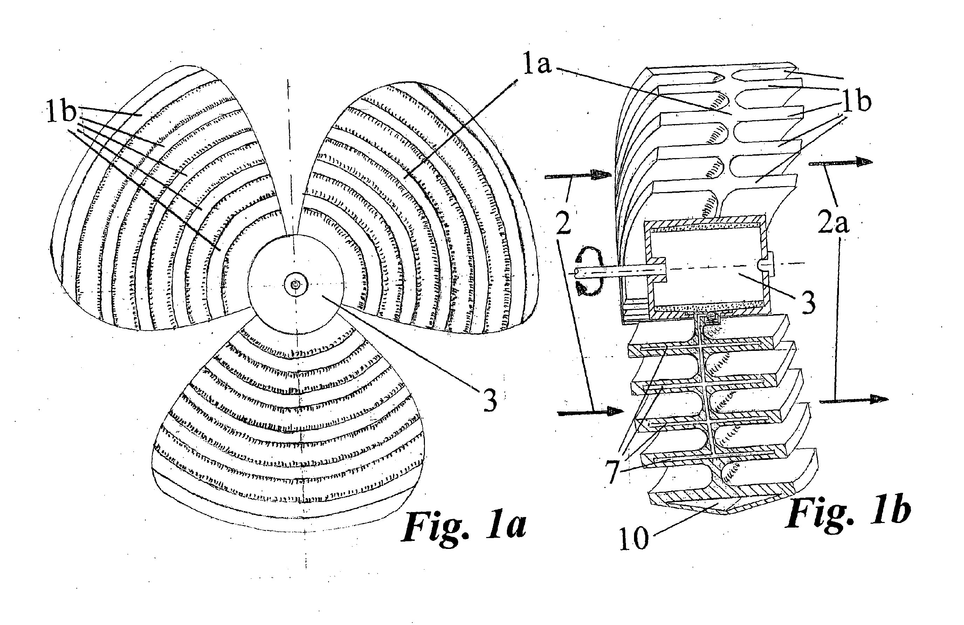

Fig. 1a stellt einen Ventilator (1) mit drei Propellerflügeln (1a) in Vorderansicht und Fig. 1b eine seitliche Schnittzeichnung dieser Vorderansicht da.
Die verdunstungsfähige Flüssigkeit (6), z.B. Wasser, wird durch einen Behälter (3), der im Achsmittelpunkt der drei Propellerflügel (1a) angeordnet ist, den Propellerflügeln (1a) gemäß der mechanisch oder elektronisch eingestellten Verdunstungsrate, dosiert zugeführt.

Bei dem im Achsmittelpunkt angeordneten Behälter (3) für Flüssigkeit (6) ist zwischen Flüssigkeitzuführung und Propellerflügel (1a) eine Vorrichtung (z.B. Ventil, Membran), die bei Stillstand der rotierenden Propellerflügel (1a) des Ventilators (1) verhindert, dass die Flüssigkeit (6) der Schwerkraft entsprechend in einzelne Propellerflügel (1a) einsickert und bei wiedereinschalten des Ventilators (1) durch die unterschiedliche Flüssigkeitsaufnahme der Propellerflügel (1a) zu Unwucht führt.

Die Flüssigkeit (6) wird vom Behälter (3) mittels einer Zufuhrleitung (7) den flüssigkeitauf nehmenden Propellerflügeln (1a) und deren Kühlrippen (1b) zugeführt, wobei die durch die Rotation der Propellerflügel (1a) verursachte anströmende Umgebungsluft durch die Verdunstungskälte gekühlt wird. An der Propellerflügelspitze ist eine Flüssigkeitsammelekammer (10) angeordnet, die überschüssige Flüssigkeit (6) sammelt und in den Behälter (3) zurückführt oder anderweitig verwendet.

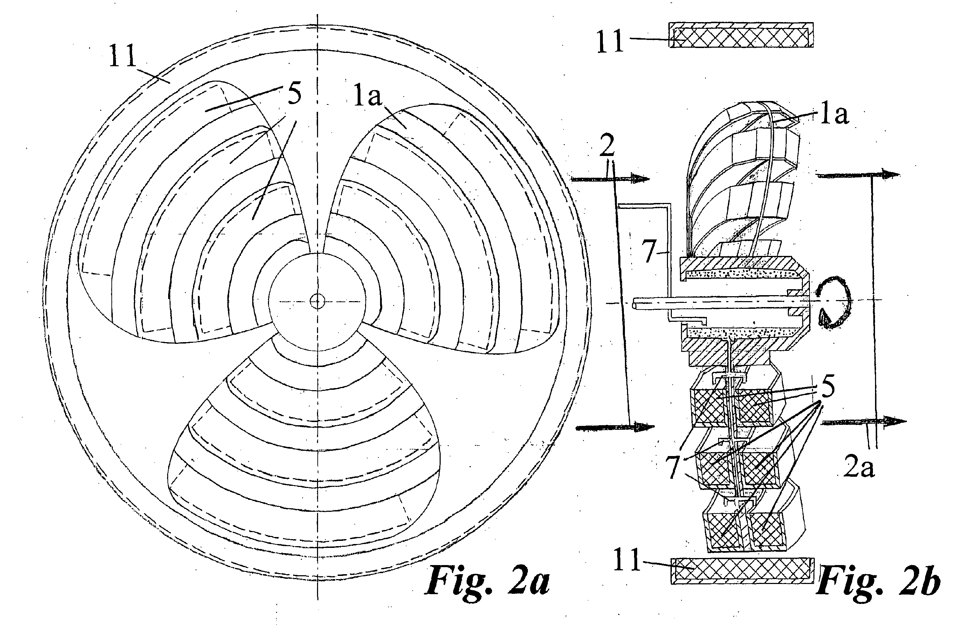

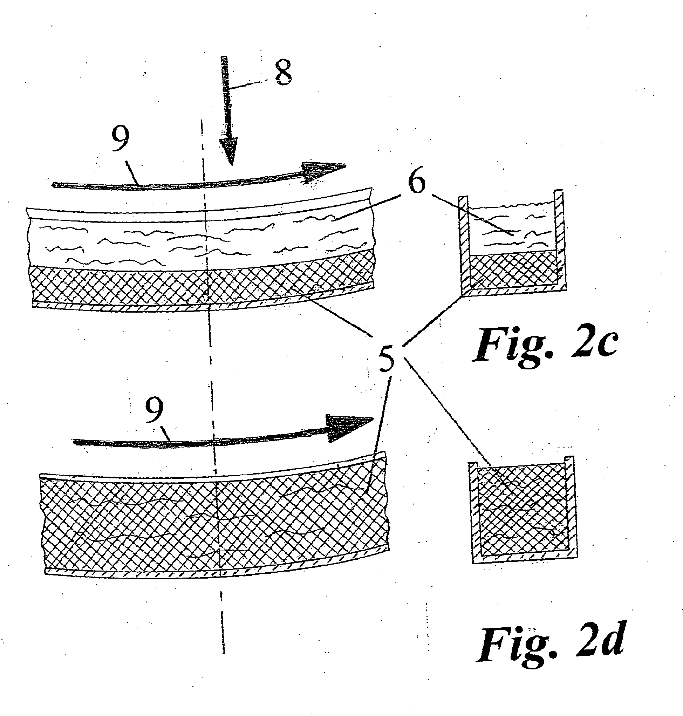

Fig. 2a stellt einen Ventilator (1) mit drei Propellerflügeln (1a) in Vorderansicht und Fig. 2b eine seitliche Schnittzeichnung dieser Vorderansicht dar. Fig.2 c und Fig. 2d sind teilschnittartige Ergänzungen.

Die verdunstungsfähige Flüssigkeit (6) wird über eine Zuführleitung (7) von einem externen Behälter in eine im Achszentrum der Propellerflügel (1a) befindlichen mit mineralstoffabweisenden (z.B. wegen Verkalkung) Filter ausgestatteten Behälter (3) eingebracht und über weitere Zufuhrleitungen (7) den Propellerflügeln (1a) zugeführt. Diese Propellerflügel (1a) sind mit einer der einwirkenden Fliehkraft (8) entgegenwirkenden Vorrichtung ausgestattet, die in einem Flüssigkeitsundurchlässigen Behältnis eine flüssigkeitaufsaugende schwammartige Substanz (5) beinhaltet. Diese schwammartige Substanz (5) wird durch die Zufuhrleitung (7) mit verdunstungsfähiger Flüssigkeit (6) beaufschlagt, wobei die schwammartige Substanz (5) im entspannten Zustand (Fig. 2d) die Flüssigkeit (6) hält und bei rotierender Drehbewegung (9) der Propeflerflügel (1a) fliehkraftbedingt zusammengedrückt wird (Fig.2c) und die verdunstungsfähige Flüssigkeit (6) ungehindert auf der schwammartigen Substanz (5) im Luftstrom (2) verdunsten kann und so den Luftstrom (2a) kühlt.

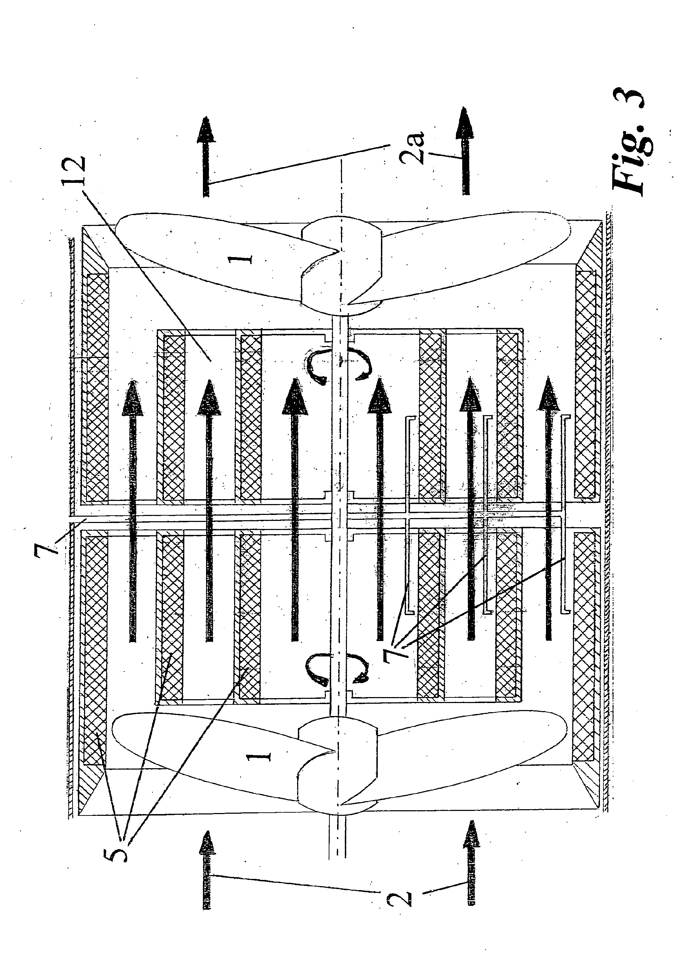

Fig. 3 zeigt als Funktionsbeispiel Ventilatoren (1) in einer rotierenden Verdunstungskammer (12). Je stärker eine Luftbewegung über eine verdunstungsfähige Flüssigkeit (6) ist, desto stärker ist die Verdunstungsrate mit dem angestrebten Kühleffekt. Die durch mindestens einen Ventilator (1) angesaugte Umgebungsluft wird durch eine Verdunstungskammer (12) geleitet, in der sich verdunstungsfähige Flüssigkeit (6) befindet, die der schwammartigen Substanz (5) über eine Zufuhrleitung (7) zugeleitet wird. Diese Flüssigkeit (6) kann sich, in einer ruhenden, mit dem Ventilator (1) rotierenden oder in Gegenrichtung rotierenden Trommel befinden, um den Luftstrom in der Kammer und somit den Kühleffekt im Luftstrom (2a) zu verstärken. Bei konstruktionsbedingt ruhender Trommel rotiert die in der Trommel befindliche Zufuhrleitung (7).

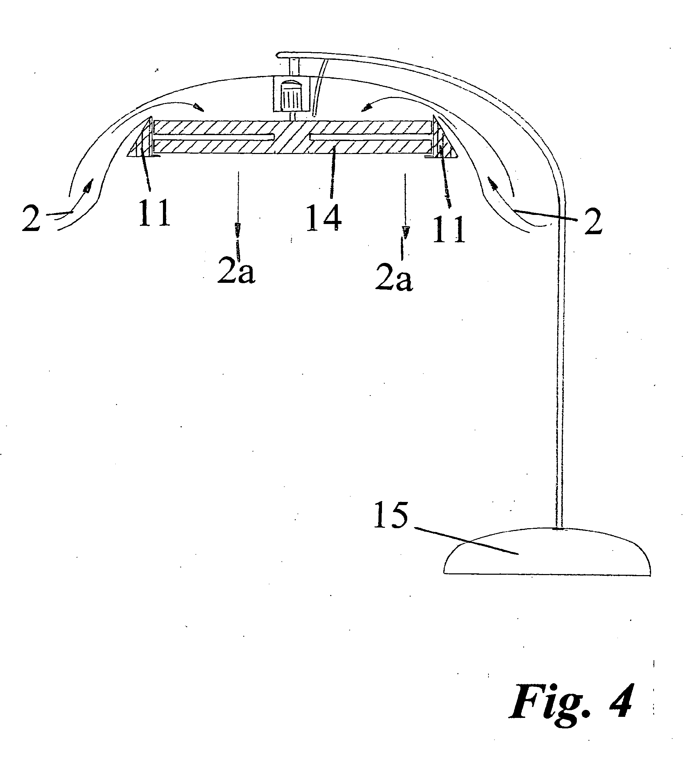

Fig. 4 zeigt eine kühlende Verdunstungsvorrichtung, die vorzugsweise unter einem Sonnenschirm (13), einer Markise, eines überdachten Balkons oder vergleichbarer Örtlichkeiten, Anwendung findet. Generell gilt, dass der rotierende Verdunstungskörper (14) thermisch bedingt Kühlung verschafft, mit oder ohne ventilatorunterstützte Luftbewegung.
Die angesaugte Umgebungsluft wird durch den mittels aus einem Wassertank (15) über eine Zufuhrleitung (7) getränkten Verdunstungskörper (14) thermisch bedingt, durch die gekühlte Abluft abgeführt.

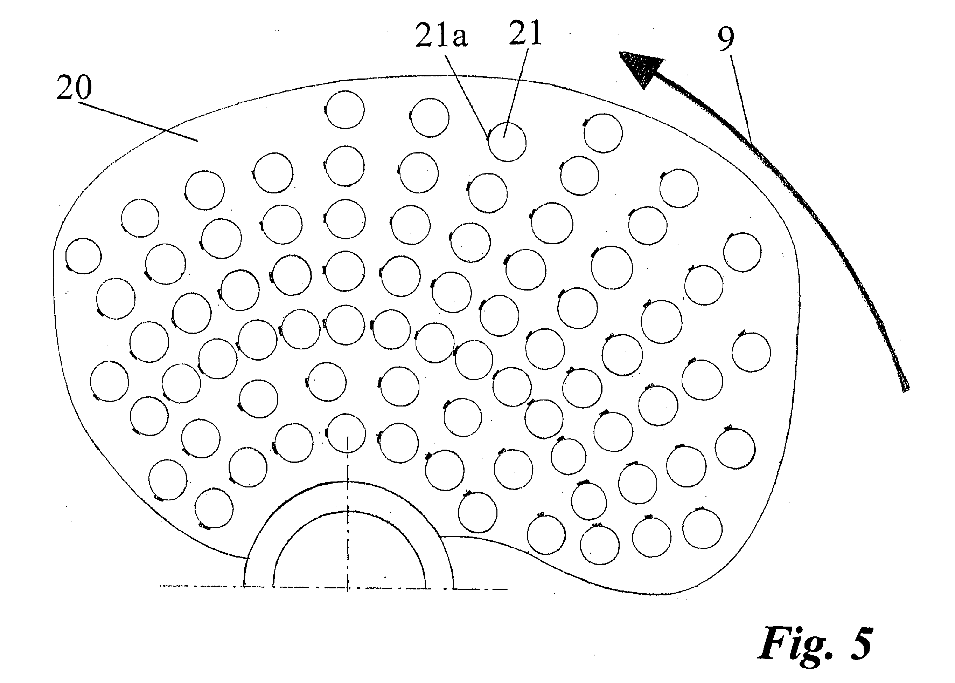

Fig. 5 zeigt, dass die Oberfläche von mindestens einem Propellerflügel (20) des Ventilators (1) mit mindestens einem individuell verstellbaren oder standardisierten Flüssigkeit versprühender Sprühkopfdüse (21a) in einem Sprühkopf (21) ausgerüstet ist, sodass der Sprühnebel nach verlassen der Oberfläche des Propellerflügels (20) im abgehenden Luftstrom verdunstet, bevor er als Feuchtigkeit auf ein Hindernis stößt oder bei entsprechender Einstellung auf einem Hindernis verdunstet.

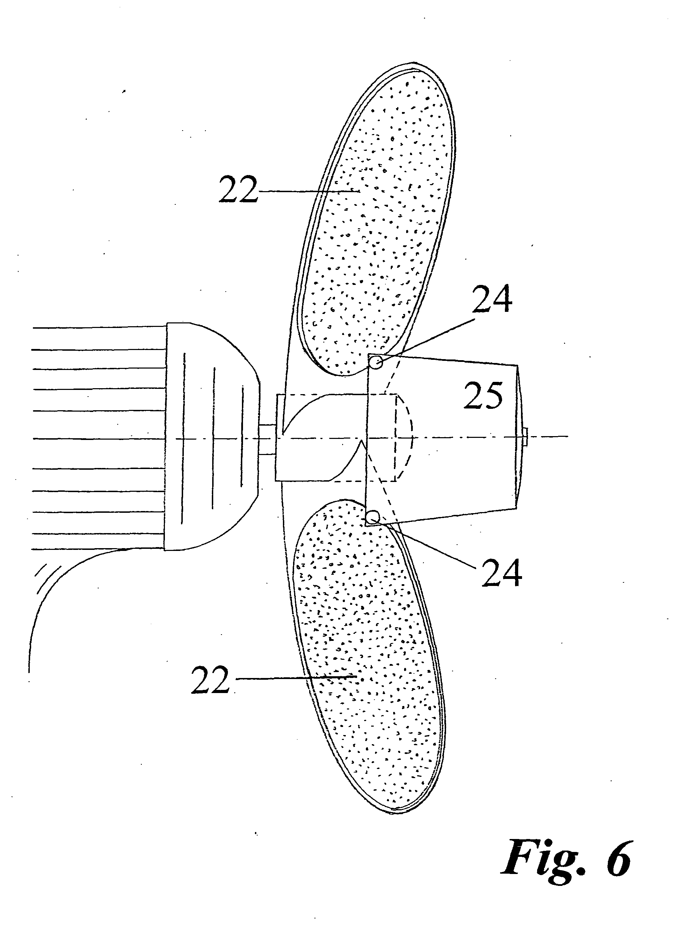

Fig. 6 stellt einen herkömmlich bekannten Ventilator dar, der mit zusätzlichen Verdunstungsflächen (22) ausgestattet ist, welche durch einen Flüssigkeitsbehälter (23), der in der Mitte der Rotationsachse der Propellerflügel (20) des Ventilators (1) angeordnet ist, die Verdunstungsflächen (22) durch einen geregelten oder ungeregelten Durchlass (24) mit verdunstungsfähiger Flüssigkeit versorgt. Desweiteren wird erfindungsgemäß vorgeschlagen, das die Versorgung der zusätzlichen Verdunstungsflächen (22) durch einen externen, mit den Verdunstungsflächen (22) nicht direkt verbundenen Flüssigkeitsbehälter mit verdunstungsfähiger Flüssigkeit versorgt wird.

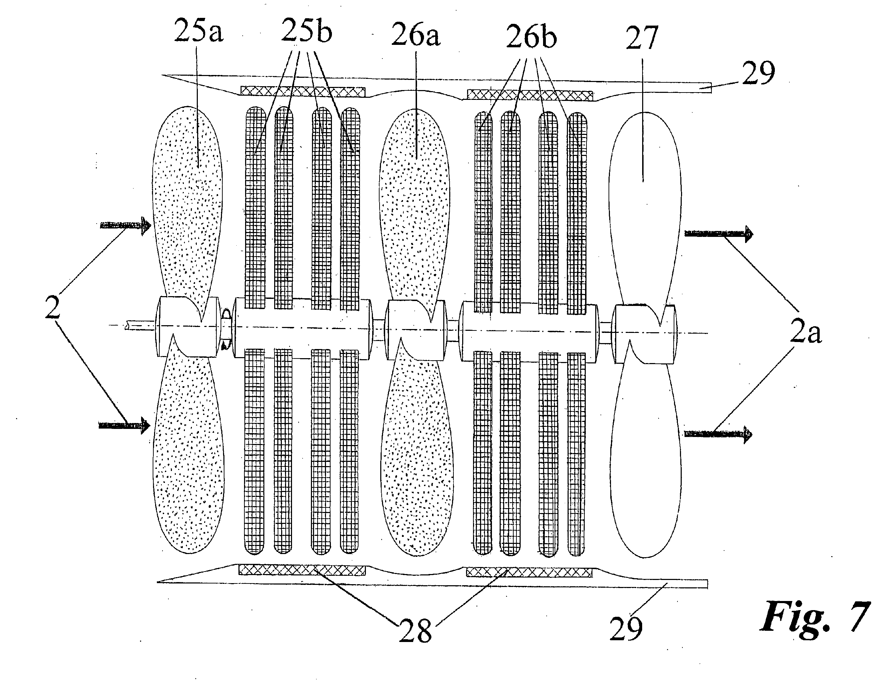

Wie in Fig. 7 dargestellt, wird erfindungsgemäß vorgeschlagen, dass Verdunstungskälte abschnittsweise in der Regel in einem Gehäuse (29) erzeugt wird, wobei Pos. 25a und Pos. 25b sowie Pos. 26a und Pos. 26b je einen Funktionsabschnitt darstellen.
In ersten Funktionsabschnitt wird nach Ansaugen des Umgebungsluft (2) die Feuchtigkeit, die mittels Propellerflügel (25a) durch Erzeugung von Verdunstungskälte entstanden ist, mittels feuchtigkeitaufnehmender Materialien (25b) aus dem Luftstrom absorbiert und durch Fliehkraft zu Nässe verdichtet und am äußeren Rand der feuchtigkeitaufnehmenden Materialien (25b) in eine Auffangvorrichtung (28) hineingeschleudert und abgeführt.

In dem nachfolgenden gekühlten und soweit wie möglich entfeuchteten Luftstrom werden erneut in einem weiteren Funktionsabschnitt Ventilatorblätter mit Verdunstungsflächen (26a) und wie im vorherigen Funktionsabschnitt nachfolgend feuchtigkeitaufnehmende Materialien (26b) angeordnet, um die Temperatur gegenüber des vorherigen Abschnitts weiter abzusenken. Nach den Funktionsabschnitten, deren Anzahl beliebig gruppiert wird, werden gegebenenfalls Propellerflügel (27) für die erneute Beschleunigung der Luftbewegung (2a) nachgeordnet. Eventueller Wärmegewinn durch die Umwandlung von gasförmig in flüssig wird derart abgeführt, dass die Kühlleistung nicht beeinträchtigt wird.

Die weitere Ausbildung des Erfindungsgegenstandes geht aus den Patentansprüchen hervor.

### Bezugszeichenliste:

**Pos. 1**
   Ventilator
**Pos. 1a**
   Propellerflügel
**Pos. 1b**
   Kühlrippen vom Propellerflügel
**Pos. 2**
   eingesaugter Luftstrom (umgebungswarm)
**Pos. 2a**
   abgehender Luftstrom (mittels Verdunstungskälte gekühlt)
**Pos. 3**
   Wasserbehälter im Zentrum der Propeller
**Pos. 5**
   dauerelastische schwammartige Substanz
**Pos. 6**
   Flüssigkeit
**Pos. 7**
   Zufuhrleitung für Flüssigkeit
**Pos. 8**
   Fliehkraft
**Pos. 9**
   Drehrichtung
**Pos. 10**
   Sammelkammer für Restflüssigkeit, die in den Zentralbehälter zurückgeführt wird
**Pos. 11**
   Spritzschutzring mit schwammartiger Substanz
**Pos. 12**
   Rotationstrommel in Verdunstungskammer (zum Verstärken der Kühlung)
**Pos. 13**
   Sonnenschirm
**Pos. 14**
   Feuchtigkeitaufnehmender gasdurchlässiger Rotationskörper für Verdunstungskälte mit überwiegend thermischer Luftbewegung

### Benennnung:

### Figurenliste:

**Fig. 1a**
   Ventilatorblätter mit Verdunstungsrippen in Vorderansicht
**Fig. 1b**
   Ventilatorblätter mit Verdunstungsrippen in Seitenansicht (Schnittzeichnung)
**Fig. 2a**
   Ventilatorblätter mit flüssigkeithaltendem Material in Vorderansicht
**Fig. 2b**
   Ventilatorblätter mit Flüssigkeithaltendem Material in Seitenansicht (Schnittzeichnung)
**Fig. 2c**
   dauerelastische schwammartige Substanz unter Fliehkrafteinwirkung (Schnittzeichnung)
**Fig. 2d**
   dauerelastische schwammartige Substanz im entspannten Zustand (Schnittzeichnung)
**Fig. 3**
   Ventilatoren mit zusätzlicher Verdunstungskammer (Teilschnittzeichnung) - Trommel in Richtung drehend mit Propeller, gegen Drehrichtung von Propeller drehend oder stehende Trommel bestehend aus Material, dass kühlende Verdunstung ermöglicht, wobei hier eine rotierende Flüssigkeitssprühvorrichtung vorgesehen ist.
**Fig. 4**
   Sonnenschirm mit Rotationskörper für Verdunstungskälte mit überwiegend thermischer Luftbewegung
**Fig. 5**
   Ventilatorblatt / Propellerflügel mit Sprühköpfen
**Fig. 6**
   Ventilatorblätter/Propellerflügel mit zusätzlich angebrachter Verdunstungsfläche mit integrierten Behälter für die Verdunstungsflüssigkeit
**Fig.** 7
   Ventilatorblätter/Propellerflügel mit Kühleffekt durch Verdunstungskälte in Reihe gestaffelt angeordnet, mit feuchtigkeitentziehenden Materialien zur abschnittsweisen Verstärkung des Kühleffekt durch Verdunstungskälte
**Pos. 15**
   Wassertank
**Pos. 17**
   Vibriationsvorrichtung
**Pos. 20**
   Ventilatorblatt / Propellerflügel (mit oder ohne Verdunstungsflächen)
**Pos. 21**
   Sprühkopf (mit oder ohne Verdunstungsoberfläche, die bei Betrieb des Ventilators gegebenenfalls Verdunstungskälte abgibt)
**Pos. 21a**
   Sprühkopfdüse
**Pos. 22**
   zusätzlich angebrachte Verdunstungsfläche auf einem herkömmlichen Ventilatorblatt / Propellerflügel
**Pos. 23**
   Behälter, der die Flüssigkeit mittels Fliehkraft in die Verdunstungsflächen (siehe Pos. 22) einbringt
**Pos. 24**
   Durchlass für die Flüssigkeit vom Flüssigkeitsbehälter zu den Verdunstungsflächen (siehe Pos. 22 und 23)
**Pos. 25a** (Funktionseinheit mit Pos. 25b)
   Ventilatorblatt/Propellerflügel mit Verdunstungsflächen
**Pos. 25b** (Funktionseinheit mit Pos. 25a)
   Feuchtigkeitaufnehmendes Material (hier mittig auf der Achse der Ventilatoren rotierend) **Pos. 26a** (Funktionseinheit mit Pos. 26b)
   Ventilatorblatt/Propellerflügel mit Verdunstungsflächen
**Pos. 26b** (Funktionseinheit mit Pos. 26a)
   Feuchtigkeitaufnehmendes Material (hier mittig auf der Achse der Ventilatoren rotierend)
**Pos. 27**
   Ventilatorblatt/Propellerflügel ohne Verdunstungsflächen ( hier zum zusätzlichen Beschleunigen der Gas(Luft)bewegung
**Pos. 28**
   Auffangvorrichtung (von der weggeschleuderten Feuchtigkeit/Nässe vom rotierenden feuchtigkeitaufnehmenden Materials (siehe Pos. 25b und Pos. 26b)
**Pos. 29**
   Gehäuse

## Patentansprüche

1. **Ventilator mit Kühleffekt durch Verdunstungskälte, dadurch gekennzeichnet, dass** mindestens ein Propellerflügel (1a) eines Ventilators (1) derart in seiner materiellen Konsistens beschaffen ist, dass er verdunstungsfähige Flüssigkeit (6) aufnehmen kann, dass der durch den um seine Achse rotierenden Propellerflügel (1a) erzeugte angesaugte Luftstrom (2) in Folge die verdunstungsfähige Flüssigkeit (6) auf der Oberfläche der Propellerflügel (1a) verdunstet, sodass durch die Verdunstung die Abluft (2a) gekühlt wird.

2. (Fig. 1a, 1b)
**Ventilator mit Kühleffekt durch Verdunstungskälte, nach Anspruch 1, dadurch gekennzeichnet, dass** mindestens ein Propellerflügel (1a) mit mindestens einer Verdunstung erzeugenden Kühlrippe (1b) ausgestattet ist.

3. (Fig. 2a-2d)
**Ventilator mit Kühleffekt durch Verdunstungskälte, nach Anspruch 1, dadurch gekennzeichnet, dass** die verdunstungsfähige Flüssigkeit (6) in einer der Fliehkraft (8) entgegenwirkenden Vorrichtung in einer schwammartigen Substanz (5) gehalten wird, die sich unter der Fliehkraft (8) verdichtet und die verdunstungsfähige Flüssigkeit (6) dem Luftstrom (2) ungehindert aussetzt, sowie im nicht rotierenden Ruhezustand die Flüssigkeit (6) wie eine schwammartige Substanz (5) hält.

4. (Fig. 3)
**Ventilator mit Kühleffekt durch Verdunstungskälte, nach Anspruch 1, dadurch gekennzeichnet, dass** in einen, von einem Ventilator (1) erzeugten Luftstrom (2) stationäre oder rotierende Kammern (12) angeordnet sind, wobei in diesen Kammern (12) eine schwammartige Substanz (5) mit verdunstungsfähiger Flüssigkeit (6) aus Zufuhrleitungen (7) beaufschlagbar ist und über den Luftstrom (2) Verdunstungskälte erzeugt wird.

5. (Fig. 4)
**Ventilator mit Kühleffekt durch Verdunstungskälte, nach Anspruch 1 und 3, dadurch gekennzeichnet, dass** unter einem Sonnenschirm (13), einer Markise oder einer von der Bestimmung vergleichbaren Vorrichtung ein flügel- und/oder scheibenförmig gasdurchlässiger Verdunstungskörper (14) in Rotation.versetzt wird, der entgegen der Fliehkraft (8) die Flüssigkeit (6) hält und bei hinzufügen von verdunstungsfähiger Flüssigkeit (6) auf die Oberfläche der rotierenden Form, mittels Verdunstung der Flüssigkeit (6) die eingeflossene Umgebungsluft durch das durch die Verdunstung gekühlte Gas thermisch bedingt oder mit Hilfe eines Ventilators (1) ableitet.

6. (Fig. 4)
**Ventilator mit Kühleffekt durch Verdunstungskälte, nach Anspruch 1, 3 und 5, dadurch gekennzeichnet, dass** ein im Ruhezustand materialbedingt flexibler Körper in Flügel- oder Scheibenform im rotierendem Betriebszustand eine weitestgehend stabile Form annimmt.

7. (Fig. 4)
**Ventilator mit Kühleffekt durch Verdunstungskälte, nach Anspruch 1, 3 bis 6, dadurch gekennzeichnet, dass** die Versorgung des Motors der flügel- oder scheibenförmigen Rotationskörper, sowie die Versorgung der Verdunstungskörper (14), mit verdunstungsfähiger Flüssigkeit (6) mittels regenerativ erzeugter Energie erfolgt, z.B. Photovoltaik, die bautechnisch dem Sonnenschirm, der Markise oder vergleichbarer Vorrichtungen zugeordnet ist.

8. **Ventilator mit Kühleffekt durch Verdunstungskälte, nach Anspruch 1 und 3, dadurch gekennzeichnet, dass** an den Flügelspitzen der Propeller (1a) ein flüssigkeitsundurchlässige Flüssigkeitssammelkammer (10) integriert ist, die durch eine Schlauchleitung mittels einer Pumpvorrichtung die Flüssigkeit (6) einem Flüssigkeitsbehälter zuleitet.

9. **Ventilator mit Kühleffekt durch Verdunstungskälte, nach vorgenannten Ansprüchen, dadurch gekennzeichnet, dass** der Sogbereich der Propellerflügel mit mindestens einem Pollenschutzgitter ausgestattet ist.

10. **Ventilator mit Kühleffekt durch Verdunstungskälte, nach Anspruch 1 und 3, dadurch gekennzeichnet, dass** der Behälter (3) im Drehzentrum der Propellerflügel (1a) angeordnet ist und mit mindestens einem Ventil zum jeweiligen Propellerflügel (1a) ausgestattet ist.

11. **Ventilator mit Kühleffekt durch Verdunstungskälte, nach Anspruch 1 und 3, dadurch gekennzeichnet, dass** der Behälter 83) außerhalb des Ventilators (1) angeordnet ist und die verdunstungsfähige Flüssigkeit (6) mindestens einem Propellerflügel (1a) zugeführt wird.

12. **Ventilator mit Kühleffekt durch Verdunstungskälte, nach einem der vorgenannten Ansprüche, dadurch gekennzeichnet, dass** der Kühleffekt durch Verdunstungskälte bei Generatoren und/oder Motoren Anwendung finden.

13. **Ventilator mit Kühleffekt durch Verdunstungskälte, Anspruch 1 und 3, dadurch gekennzeichnet, dass** die von einem rotierenden Ventilator (1) abspritzende Feuchtigkeit (6) mittels eines Spritzschutzringes (11) aufgefangen und abgeleitet wird.

14. (Fig. 5)
**Ventilator mit Kühleffekt durch Verdunstungskälte, nach Anspruch 1 bis 13,**
**dadurch gekennzeichnet, dass** an mindestens einem Propellerflügel (1a) der verdunstungsfähige Flüssigkeit (6) aufnehmen kann Sprühköpfe(21) angeordnet sind, die verdunstungsfähige Flüssigkeit (6) in der Menge ausstoßen, dass die Flüssigkeit (6) nach austreten aus den Sprühkopfdüsen(21a) unabhängig von der Oberfläche der Propellerflügel (1a) in dem vom Propellerflügel (1a) wegströmenden Luftstrom (2a) verdunstet.

15. **Ventilator mit Kühleffekt durch Verdunstungskälte, nach Anspruch 1, 3 und weiteren Ansprüchen, dadurch gekennzeichnet, dass** die verdunstungsfähige Flüssigkeit (6) von mindestens einem Propellerflügel (1a) zusätzlich auf einem vom Ventilator(1) unabhängigen Körper auftrifft und dort teilweise oder vollständig verdunstet.

16. **Ventilator mit Kühletfekt durch Verdunstungskälte, nach Anspruch 1 bis 15,**
**dadurch gekennzeichnet, dass** dem feuchtkühlen Luftstrom Feuchtigkeit entzogen wird, in dem der feuchtkühle Luftstrom durch feuchtigkeitaufnehmendes Material geleitet wird, welches die Feuchtigkeit von dem Luftstrom trennt oder absorbiert und die Feuchtigkeit ableitet.

17. (Fig. 7)
**Ventilator mit Kühleffekt durch Verdunstungskälte, nach Anspruch 1 bis 16,**
**dadurch gekennzeichnet, dass** der feuchtkühle Luftstrom durch feuchtigkeitauf nehmendes rotierendes Material (25b, 26b) geleitet wird, welches die Feuchtigkeit durch Rotation erzeugter Fliehkraft zur Nässe verdichtet und die Nässe an geeigneter Stelle wegschleudert oder in eine Aufangvorrichtung (28) abgeleitet wird.

18. **Ventilator mit Kühleffekt durch Verdunstungskälte, nach Anspruch 1 bis 17,**
**dadurch gekennzeichnet, dass** mindestens ein Propellerflügel (1a) mit feuchtigkeitauf nehmenden Material ausgestattet ist, welcher Feuchtigkeit durch Fliekraft zur Nässe verdichtet und diese Nässe aus dem Luftstrom des Ventilators(1) wegschleudert.

19. **Ventilator mit Kühleffekt durch Verdunstungskälte, nach Anspruch 1 bis 18,**
**dadurch gekennzeichnet, dass** das luftfeuchtigkeitaufnehmende Material in mindestens einem Propellerflügel (1a) derart angeordnet ist, dass es einen Teil der Verdunstungsfeuchtigkeit über den Luftweg des eigenen Propellerflügels(1a) und die der anderen Propellerflügel (1a) aufnehmen kann.

20. (Fig. 7)
**Ventilator mit Kühleffekt durch Verdunstungskälte, nach Anspruch 1 bis 19,**
**dadurch gekennzeichnet, dass** Feuchtigkeit verdunstende Propellerflügel (25a, 26a) und luftfeuchtigkeitaufnehmende Materialien (25b, 26b) derart abwechselnd im Gas(Luft)stromangeordnet sind, dass der Kühleffekt abschnittsweise gegenüber der Umgebungsluft verstärkt wird und gegebenenfalls durch einen nachgeordneten Propeller (27) erneut beschleunigt wird.

21. **Ventilator mit Kühleffekt durch Verdunstungskälte, nach einem der vorgenannten Ansprüche, dadurch gekennzeichnet, dass** der feuchtkühle Gasstrom durch einen indirekten Wärmeübertrager geführt wird, durch das das wärmere Gas gekühlt wird und im Feuchtigkeitsverhältnis unverändert bleibt.

22. **Ventilator mit Kühleffekt durch Verdunstungskälte, nach Anspruch 1 bis 21, dadurch gekennzeichnet, dass** die Rotationsgeschwindigkeit der Propellerflügel (1a) soweit reduziert wird, dass der Kühleffekt nur noch gering stattfindet, eine Verdunstung zur Luftbefeuchtung jedoch noch gegeben ist.

23. **Ventilator mit Kühleffekt durch Verdunstungskälte, nach Anspruch 1 bis 22, dadurch gekennzeichnet, dass** die verdunstungsfähige Flüssigkeit von Außen auf dem Luftweg mindestens einem Propellerflügel (1a), der mit feuchtigkeithaltendem Material ausgestattet ist, aufgebracht wird.

24. (Fig. 6)
**Ventilator mit Kühleffekt durch Verdunstungskälte, nach Anspruch 1 bis 23, dadurch gekennzeichnet, dass** die Zusatzverdunstungsflächen (22) auf mindestens einer Seite von mindestens einem der Propellerflügel (1a) ohne oder mit Durchlass (24) zu einem Behälter (23) angeordnet sind, wobei der Behälter (23) die Zusatzverdunstungsflächen (22) mittels Durchlass (24) mit verdunstungsfähiger Flüssigkeit versorgt.

25. **Ventilator mit Kühleffekt durch Verdunstungskälte, nach Anspruch 1, dadurch gekennzeichnet, dass** die Propellerflügel (1a) nur aus einem tragenden, z.B. gitterartigen Material bestehen, in die feststoffartige verdunstungsfähige Substanz eingebettet ist.

26. **Ventilator mit Kühleffekt durch Verdunstungskälte, nach Anspruch 1 bis 25, dadurch gekennzeichnet, dass** mittels Sensoren der Feuchtigkeitsgehalt und die Temperatur der eingesaugten Umgebungsluft des Ventilators (1) gemessen wird und mittels einer elektronischen oder anderen Steuerung die Menge der verdunstungsfähigen Feuchtigkeit auf mindestens einem Propeflerflügel (1a) regelbar ist, um den Kühleffekt manuell oder automatisch zu steuern.

27. **Ventilator mit Kühleffekt durch Verdunstungskälte, nach Anspruch 1 bis 26, dadurch gekennzeichnet, dass** die Temperatur der angesaugten Luft und des abgehenden Luftstrahls durch den Ventilator (1), sowie die Temperaturdifferenz gemessen und am Ventilatorgehäuse oder separat mittels Anzeige dargestellt wird.

28. **Ventilator mit Kühleffekt durch Verdunstungskälte, nach Anspruch 1 bis 27, dadurch gekennzeichnet, dass** mindestens ein Propellerflügel (1a) derart abgeknickt oder gebogen ist, dass der kühlende Luftstrom fokussiert wird.

29. **Ventilator mit Kühleffekt durch Verdunstungskälte, nach Anspruch 1 bis 28, dadurch gekennzeichnet, dass** die Energieversorgung über Netzanschluss und/oder netzlos (z.B. mittels Batterie oder Fotovoltaik) erfolgt.

30. **Ventilator mit Kühleffekt durch Verdunstungskälte, nach Anspruch 1 bis 29, dadurch gekennzeichnet, dass** bei gleichbleibender Umdrehungszahl der Ventilator (1) mindestens einen in seiner Längsachse verstellbaren Propellerflügel (1a) zum Regulieren der Geschwindigkeit des Luftstroms hat.
